# EUROPEAN PATENT APPLICATION

(11) **EP 4 436 327 A2**
(43) Date of publication of application: **25.09.2024**
(21) Application number: 24165544.8
(22) Date of filing: 22.03.2024
(51) Int. Cl.: H10B 10/00, H01L 27/02, G11C 11/412

(54) **SRAM DEVICE INCLUDING BURIED BIT LINE AND BURIED WORD LINE USING BACKSIDE METAL**

(30) Priority: 23.03.2023 KR 20230038060; 06.09.2023 KR 20230118416; 21.03.2024 KR 20240039195
(71) Applicant: Samsung Electronics Co., Ltd., Suwon-si, Gyeonggi-do 16677 (KR)
(72) Inventor: CHOI, Ji-Hyun, 16677 Suwon-si, Gyeonggi-do (KR); TANG, Ho Young, 16677 Suwon-si, Gyeonggi-do (KR); LEE, Eo Jin, 16677 Suwon-si, Gyeonggi-do (KR); KIM, Tae-Hyung, 16677 Suwon-si, Gyeonggi-do (KR); JEONG, Yu Tak, 16677 Suwon-si, Gyeonggi-do (KR)
(74) Representative: Kuhnen & Wacker Patent- und Rechtsanwaltsbüro PartG mbB

(57) **Abstract**

A memory device is provided. The memory device includes a memory cell array including a plurality of memory cells arranged in a plurality of columns and rows and including first and second memory cells in a same column and different rows, the plurality of columns intersecting the plurality of rows in a plan view, a first bit line transistor electrically connected between the first memory cell and a first bit line metal line and a second bit line transistor electrically connected between the second memory cell and a second bit line metal line, wherein the first bit line metal line is on an upper surface of the memory cell array, and the second bit line metal line is on a lower surface of the memory cell array opposite the upper surface of the memory cell array.

## Description

### BACKGROUND

The present disclosure relates generally to a static random memory device, and more particularly, to a static random memory device including a bit line and a word line using a backside metal.

Technologies related to semiconductor devices have continued to grow and develop worldwide due to active demands of semiconductor users and constant efforts of semiconductor manufacturers. Furthermore, the semiconductor manufacturers are striving to further miniaturize, increase high integration and increase capacity of semiconductor devices, while accelerating research and development so that more stable and active operations are performed and faster. These efforts of the semiconductor manufacturers have led to advances in micro-process technology, ultra-small device technology and circuit design technology, with remarkable achievements in technologies of semiconductor memory cells such as dynamic random access memory (DRAM) and static random access memory (SRAM).

In the case of random access memory, as the degree of integration is increased, a length of a bit line or a word line is typically increased and the number of connected devices is increased. However, as the number of bit lines or word lines is increased and the length of each bit line or each word line is increased, parasitic capacitance is increased accordingly due to characteristics of a metal line, and there is a difficulty in design that bit line and word line routing should be considered.

### BRIEF SUMMARY

The present disclosure, as manifested by one or more embodiments thereof, relates particularly to a static random memory device including a bit line and a word line using a backside metal. One or more embodiments of the present disclosure provide a memory device that may improve device performance and reliability while reducing a routing area. In some embodiments, a memory device is provided that may reduce an additional area for routing of a bit line metal line.

One embodiment of the present disclosure provides a memory device comprising a memory cell array including a plurality of memory cells connected to a plurality of columns and rows and including first and second memory cells associated with the same column and in different rows, a first bit line transistor connected between the first memory cell and a first bit line metal line and a second bit line transistor connected between the second memory cell and a second bit line metal line, wherein the first bit line metal line is on an upper surface of the memory cell array, and the second bit line metal line is on a lower surface of the memory cell array.

Another embodiment of the present disclosure provides a memory device comprising a pair of first bit line metal lines at a first metal level, a memory cell array on a substrate above the first metal level, including first and second memory cells associated with the same column, first and second power supply metal lines and a pair of second bit line metal lines, which are at a second metal level above the substrate and a sense amplifier disposed in the substrate and electrically connected to the pair of first bit line metal lines and the pair of second bit line metal lines, wherein the first memory cell is connected to the pair of first bit line metal lines, and the second memory cell is connected to the pair of second bit line metal lines.

Other embodiments of the present disclosure provide a memory device comprising a memory cell array including a plurality of memory cells in a substrate, a pair of first bit line metal lines spaced apart from each other at a lower metal level below the substrate and extended in a first direction, a first power supply metal line extended in the first direction at a first upper metal level above the substrate, a pair of second power supply metal lines spaced apart from the pair of first power supply metal lines in a second direction at the first upper metal level and extended in the first direction, a pair of lower word line metal lines spaced apart from the pair of second power supply metal lines in the second direction on a first directional axis the same as that of the pair of second power supply metal lines at the first upper metal level, a pair of second bit line metal lines disposed between each of the pair of second power supply metal lines and the first power supply metal line at the first upper metal level and extended in the first direction and a plurality of upper word line metal lines extended in the second direction at a second upper metal level above the first upper metal level.

### BRIEF DESCRIPTION OF THE DRAWINGS

The above and other aspects and features of the present disclosure will become more apparent by describing in detail exemplary embodiments thereof with reference to the attached drawings, wherein like reference numerals (when used) indicate corresponding elements throughout the several views, and in which:
FIG. 1 is a schematic block diagram illustrating at least a portion of an example memory device, according to some embodiments of the present disclosure;
FIG. 2 is a schematic block diagram illustrating one embodiment of the example memory cell array of FIG. 1;
FIG. 3 is a detailed logic circuit diagram illustrating the memory cell array of FIG. 2, according to one or more embodiments of the present disclosure;
FIG. 4 is a detailed conceptual view illustrating an arrangement of bit-line metal lines of the example memory cell array of FIG. 2, according to one or more embodiments of the present disclosure;
FIG. 5 is a conceptual perspective layout view illustrating an example arrangement of a metal line of the memory cell array of FIG. 4, according to one or more embodiments of the present disclosure;
FIG. 6 is a conceptual perspective layout view illustrating an example arrangement of a first memory cell, according to one or more embodiments of the present disclosure;
FIG. 7 is a plan view illustrating the first memory cell of FIG. 6;
FIG. 8 is a cross-sectional view taken along line Y1-Y1' of the first memory cell of FIG. 7;
FIG. 9 is a conceptual perspective layout view illustrating an example arrangement of a second memory cell, according to one or more embodiments of the present disclosure;
FIG. 10 is a plan view illustrating the second memory cell of FIG.10;
FIG. 11 is a cross-sectional view taken along line Y2-Y2' of the second memory cell of FIG. 9;
FIG. 12 is a conceptual perspective layout view illustrating one column of the example memory cell array of FIG. 3, according to one or more embodiments of the present disclosure;
FIG. 13 is a cross-sectional view taken along line A1-A2 of the first memory cell and the second memory cell of FIG. 12;
FIG. 14 is a block diagram illustrating a memory device according to some embodiments;
FIG. 15 is a detailed conceptual view illustrating a word line metal line of a memory cell array according to some embodiments;
FIG. 16 is a plan view illustrating one row of a memory cell array according to some embodiments;
FIG. 17 is a cross-sectional view taken along line X1-X1' of FIG. 16;
FIG. 18 is a cross-sectional view taken along line X2-X2' of FIG. 16;
FIG. 19 is a detailed conceptual view illustrating a word line metal line of a memory cell array according to some embodiments;
FIG. 20 is a layout view illustrating one row in the memory cell array of FIG. 19;
FIG. 21 is a cross-sectional view taken along line B1-B1' of FIG. 20;
FIG. 22 is a cross-sectional view taken along line C1-C1' of FIG. 20;
FIGS. 23 and 24 are layout views illustrating a memory cell array to describe word line arrangement according to some embodiments;
FIG. 25 is a block diagram illustrating a memory device to describe arrangement of a through contact region according to some embodiments; and
FIG. 26 is a layout view illustrating the memory cell array of FIG. 25.

### DETAILED DESCRIPTION

In the present disclosure, "one side" or "one direction" and "the other side" or "the other direction" may be used as relative concepts to explain the technical spirits of the present disclosure. Therefore, 'one side' and 'the other side' may be compatible with each other without referring to specific (i.e., absolute) directions, locations or components. For example, "one side" may be interpreted as "the other side," or vice versa. The term "one side" may be replaced by an ordinal term such as "first side," and similarly the term "other side" may be replaced by the ordinal term "second side." Although ordinal terms such as first and second may be used to describe various elements or components in the present disclosure, these elements or components are not limited by these terms. These terms are only used to distinguish a single element or component from other elements or components and should not be interpreted as conveying any particular order of the elements with respect to one another. Therefore, a first element or component referred to below may be termed a second element or component, and similarly a second element could be termed a first element, without departing from the scope or technical idea of the present disclosure. In the present disclosure, the term "both sides" is intended to refer to both one surface and the other surface.

In the present disclosure, a first direction and a second direction or X-direction, Y-direction and Z-direction are used as relative concepts to more clearly explain the technical concepts of the present disclosure. Therefore, the first direction and the second direction or the X-direction, the Y-direction and the Z-direction may be compatible with each other without referring to specific directions. In the following embodiments, the first direction may be expressed as the X-direction and the second direction may be expressed as the Y-direction, or vice versa. However, the first direction and the second direction are not used interchangeably in the same embodiment.

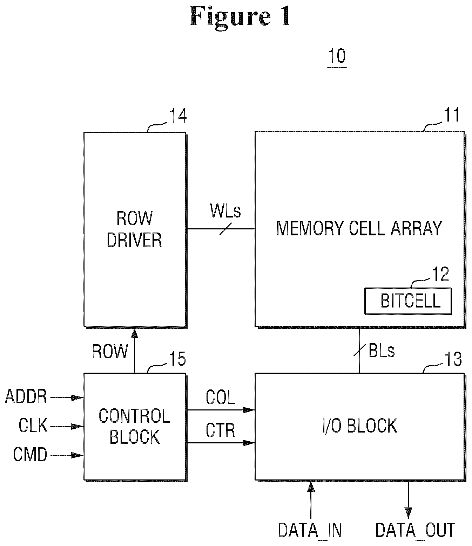

Hereinafter, a memory device according to some embodiments of the present disclosure will be described with reference to FIGS. 1 to 13.

FIG. 1 is a schematic block diagram illustrating at least a portion of an example memory device, according to some embodiments of the present disclosure.

Referring to FIG. 1, a memory device 10 may receive (e.g., from an external source) a command CMD, an address ADDR, a clock CLK, and write data DATA_IN, and may provide read data DATA_OUT (e.g., to an external device). For example, the memory device 10 may receive a command CMD (which may be referred to as a write command) indicating a write operation, an address ADDR (which may be referred to as a write address) and write data DATA_IN, and may store the write data DATA_IN in a region of a memory cell array 11, which corresponds to the address ADDR. In addition, the memory device 10 may receive a command CMD (which may be referred to as a read command) indicating a read operation and an address ADDR (which may be referred to as a read address), and may output read data DATA_OUT stored in the region of the memory cell array 11, which corresponds to the address ADDR, to the outside.

The memory cell array 11 may include a plurality of memory cells (bitcell)12. Each of the memory cells 12 may be connected to one of a plurality of word lines WLs, and may be connected to at least one of a plurality of bit lines BLs.

A row driver 14 may be connected to the memory cell array 11 through the plurality of word lines WLs. The row driver 14 may be configured to activate one word line among the plurality of word lines WLs based on a row address ROW received by the row driver 14. Therefore, memory cells, which are connected to an activated word line WL, among the plurality of memory cells 12 may be selected. That is, the row driver 14 may select one of the plurality of word lines WLs.

A control block 15 may receive the command CMD, the address ADDR and the clock CLK signals, and may generate the row address ROW, a column address COL and a control signal CTR. For example, the control block 15 may identify the read command by decoding the command CMD and generate a read signal as the row address ROW, the column address COL and the control signal CTR in order to read the read data DATA_OUT from the memory cell array 11. In addition, the control block 15 may identify the write command by decoding the command CMD, and may generate a write signal as the row address ROW, the column address COL and the control signal CTR in order to write the write data DATA_IN in a selected memory cell 12 in the memory cell array 11.

An input/output (I/O) block 13 may include a bit line precharge circuit, a column driver, a read circuit, and a write circuit in accordance with some embodiments.

According to some embodiments, the semiconductor device 10 may further include other device/circuit modules (e.g., logic devices, high frequency devices, image sensing devices, dynamic random access memory (DRAM) devices or their combination) integrated with SRAM devices.

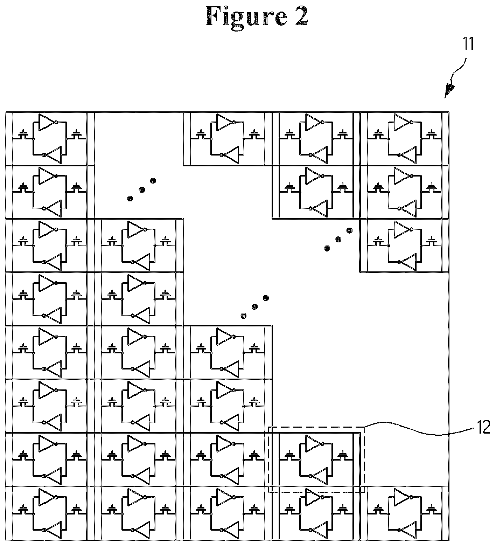

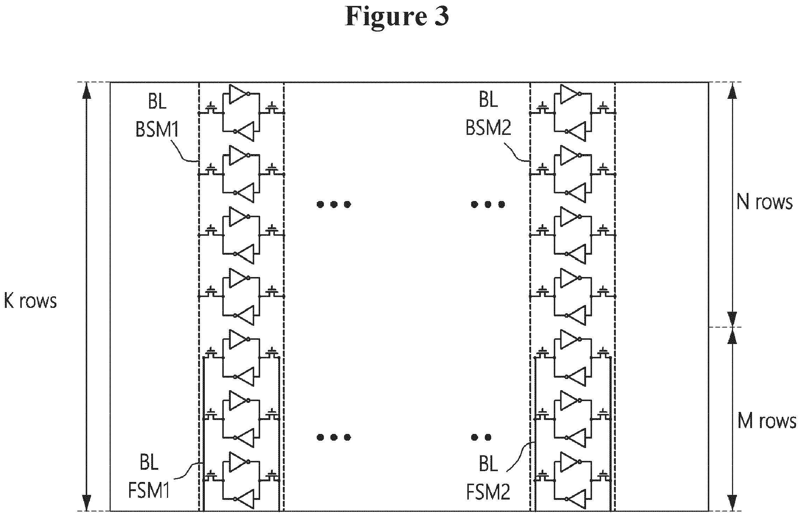

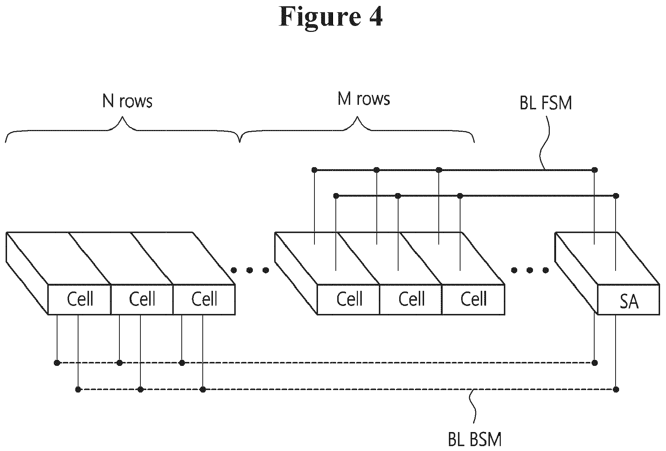

FIG. 2 illustrates one embodiment of the memory cell array 11 of FIG. 1, and FIG. 3 is a detailed logic circuit diagram illustrating the memory cell array 11 of FIG. 2. FIG. 4 is a detailed conceptual view illustrating an example arrangement of bit-line metal lines of the memory cell array 11 of FIG. 2, according to one or more embodiments.

Referring to FIG. 2, the memory cell array 11 of FIG. 1 includes a plurality of memory cells 12. The memory cells 12 are arranged into a plurality of columns and a plurality of rows. Each of the memory cells 12 may be a random access memory in accordance with some embodiments, although embodiments not limited thereto. The memory cell 12 may be, for example, a static random access memory, or may be a dynamic random access memory as another example.

In some embodiments, each column of memory cells 12 in the memory cell array 11 may extend along a first direction X, and each row thereof may extend along a second direction Y which intersects (e.g., perpendicular to) the first direction X. For example, each column may include one or more memory cells 12 configured in a line (column) along the first direction X, and each row may include one or more memory cells 12 configured in a line (row) along the second direction Y. That is, the memory cell array 11 may include memory cell(s) 12 comprised of a number of rows N1 and a number of columns N2 (N1 x N2), where N1 and N2 are positive integers; N1 may or may not be equal to N2.

Referring to FIG. 3, each of at least a subset of the memory cells 12 may include six transistors. For example, the memory cell 12 may include a bit line transistor, a complementary bit line transistor and two inverters. Each of the inverters includes a pull-up transistor and a pull-down transistor.

In some embodiments, an input terminal of the first inverter is connected to an output terminal of the second inverter, and an input terminal of the second inverter is connected to an output terminal of the first inverter. The inputs/outputs of the two inverters are connected to each other to be engaged with each other so that the memory cell 12 may store data in units of bits and thus may be also referred to as a `bit cell'.

The bit line transistor is connected to the input terminal of the first inverter, and the complementary bit line transistor is connected to the input terminal of the second inverter. A source metal of the bit line transistor is connected to the input terminal of the first inverter, and a drain metal thereof is connected to one end of a bit line metal line BL. A source metal of the complementary bit line transistor is connected to the input terminal of the second inverter, and a drain metal thereof is connected to one end of the complementary bit line metal line BL. A word line metal line is connected to respective gates of the bit line transistor and the complementary bit line transistor.

When an appropriate level word line signal is applied to the gate of the bit line transistor, the bit line transistor is turned on so that a data bit stored in the memory (i.e., bit) cell 12 is provided to a sense amplifier (not explicitly shown) connected to the other end of the bit line metal line BL, and the sense amplifier amplifies and outputs a signal received through the bit line metal line BL.

In one of a plurality of columns in the memory cell array, a first memory cell may be connected from an uppermost word line to an (n)th word line, where n is an integer, and a second memory cell may be connected from an (n+1)th word line to a lowest word line. That is, the first memory cell may be disposed in N number of rows, and the second memory cell may be disposed in M number of rows, where N and M are integers; the total number of rows K in a given column may be a sum of the N rows and M rows (i.e., K = N + M). The bit line metal line BL to which the first memory cell is connected may be implemented as a backside metal line (BL BSM) formed below a substrate (e.g., on a lower surface of the substrate) in which the memory cell array 11 is disposed (e.g., BSM1 or BSM2). According to some embodiments, a bit line using the backside metal line may be referred to as a buried bit line. The bit line metal line BL to which the second memory cell is connected may be implemented as a frontside metal line BL_FSM disposed on the substrate (e.g., on an upper surface of the substrate opposite the lower surface) in which the memory cell array 11 is disposed (e.g., FSM1 or FSM2).

Referring to FIG. 4, the bit lines of the first memory cell and the second memory cell, connected in the same column, may be different from each other depending on whether they are disposed on a frontside or a backside based on the substrate, but are connected to the same sense amplifier (SA).

In the shown example, in each column, the first memory cell is described as being disposed in N number of rows and the second memory cell is described as being disposed in M number of rows. However, according to another embodiment, in a first column, the first memory cell may be disposed in N number of rows and the second memory cell may be disposed in M number of rows. In a second column adjacent to the first column, the second memory cell may be disposed in N number of rows and the first memory cell may be disposed in M number of rows. For example, the memory cell array includes a plurality of sub-groups. A first sub-group of the plurality of sub-groups is electrically connected to a sense amplifier such that the first memory cell is disposed and then the second memory cell is disposed in a first direction from an uppermost word line to a lowest word line in first column. A second sub-group of the plurality of sub-groups is electrically connected to the sense amplifier such that the second memory cell is disposed and then the first memory cell is disposed in the first direction in second column. The first column of the first sub-group and the second column of the second sub-group are alternately disposed in a second direction intersecting the first direction, the first and second directions being parallel to the upper surface of the memory cell array. According to various embodiments, the first column and the second column may be alternately disposed one by one (1-2-1-2-1-2-...), or at least two columns may be alternately disposed (1-1-2-2-1-1-2-2-...) as the first column and the second column. It is to be appreciated, however, that embodiments are not limited to any specific arrangement of the columns of memory cells.

Alternatively, in the shown example, in each column, the first memory cell is described as being disposed in N number of higher rows from the uppermost word line to the lowest word line and the second memory cell is described as being disposed in M number of lower rows.

However, according to another embodiment, the first memory cell and the second memory cell may be alternately disposed by k number of sub-groups from the uppermost word line to the lowest word line in the same column (k is a natural number greater than or equal to 2). For example, in one column, the first memory cell may be disposed in first to tenth rows, the second memory cell may be disposed in 11th to 20th rows, the first memory cell may be disposed in 21st to 30th rows, and the second memory cell may be disposed in 31st to 41st rows. Therefore, capacitance between adjacent bit lines may be reduced and an additional area for routing based on density of the bit line may not be required.

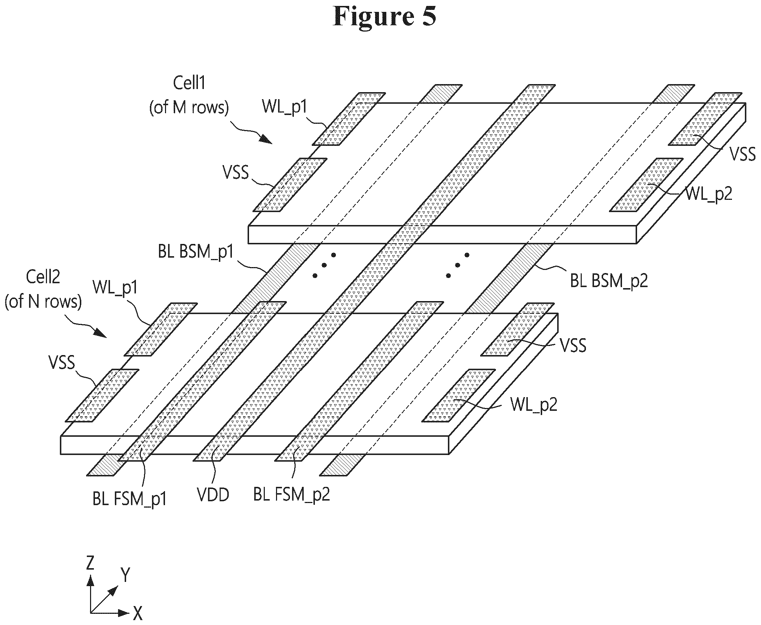

FIG. 5 is a conceptual perspective layout view illustrating an example arrangement of a metal line of the memory cell array of FIG. 4, according to one or more embodiments.

The following description will be based on the arrangement of the substrate and the bit line metal line. For convenience of description, the arrangement on the metal lines and the substrate is provided to describe a relative position with respect to the X-Y plane of the substrate, and may be referred to as a first metal level, a second metal level, a third metal level, and the like. Components of other levels may be disposed between respective planar levels. For example, another metal component may be further disposed, for example, between the substrate and the first metal level. The metal component may be a via, a contact, or a through electrode (e.g., through silicon via).

Referring to FIG. 5, a first memory cell Cell1 and a second memory cell Cell2 are respectively disposed in the same column and different rows; the first memory cell Cell1 may be disposed in a first subset of rows (N rows) and the second memory cell Cell2 may be disposed in a second subset of rows (M rows). A plurality of transistors included in each of the memory cells are formed and disposed in the substrate.

The first metal level includes metal lines disposed on the substrate while being spaced apart from the substrate in the Z-direction perpendicular to the upper surface of the substrate. The first metal level, which may be a frontside metal level, may include power supply metal lines VDD and VSS, first bit line metal lines BL_FSM_p1 and BL_FSM_p2, and word line metal lines WL_p1 and WL_p2. The first power supply metal line VDD may extend lengthwise in the Y-direction parallel to the upper surface of the substrate, and the second power supply metal line VSS may extend in the Y-direction and be spaced apart from the first power supply metal line VDD in the X-direction. For example, the power supply voltage may be applied to the first power supply metal line VDD, and the power ground voltage may be applied to the second power supply metal line VSS. The lower word line metal lines WL_p1 and WL_p2 may extend in the Y-direction on a Y-axis the same as that of the second power supply metal line VSS (i.e., the lower word line metal lines WL_p1 and WL_p2 may be aligned with the second power supply metal line VSS in the X-direction) while being spaced apart from the second power supply metal line VSS in the Y-direction.

The second metal level includes metal lines spaced apart from the substrate in the Z-direction under the substrate (e.g., on a bottom surface of the substrate). The second metal level includes second bit line metal lines BL_BSM_p1 and BL BSM_p2.

The third metal level may include metal lines disposed on the first metal level while being spaced apart from the first metal level in the Z-direction. The third metal level may include, for example, an upper word line metal line.

According to one embodiment, each metal level may include metal lines extended in one direction. For example, the first and third metal levels may include metal lines extended in the Y-direction, and the second metal level may include metal lines extended in the X-direction parallel to the upper surface of the substrate and intersecting the Y-direction. According to another embodiment, the first to third metal levels may include bi-directional metal lines extending in the X-direction and the Y-direction, respectively.

The first power supply metal line VDD may extend in the Y-direction on an upper surface of the substrate on a center point in the X-direction of the first and second memory cells Cell1 and Cell2. A pair of the second power supply metal lines VSS may extend in the Y-direction while being spaced apart from the first power supply metal line VDD toward both sides in the X-direction. A pair of the lower word line metal lines WL_p1 and WL_p2 may also extend in the Y-direction while being spaced apart from the first power supply metal line VDD toward both sides in the X-direction. The pair of the second power supply metal lines VSS and the pair of the lower word line metal lines WL_p1 and WL_p2 are spaced apart from each other in the Y-direction on the same direction axis (e.g., Y-axis). The (2-1)th power supply metal line VSS and the first lower word line metal line WL_p1 are disposed to be point-symmetrical to the (2-2)th lower word line metal line WL_p2 and the second power supply metal line VSS. That is, in view of the Y-axis direction, the first lower word line metal line WL_p1 is disposed behind the (2-1)th power supply metal line VSS, whereas the (2-2)th lower word line metal line for WL_p2 is disposed in front of the second power supply metal line VSS.

The first memory cell Cell1 is electrically connected to a pair of the first bit line metal lines BL BSM_p1 and BL BSM_p2 and the pair of the lower word line metal lines WL_p1 and WL_p2, which are disposed at a lower metal level below the substrate. The term "connected" (or "connecting," "contact," "contacting," or like terms), as may be used herein, is intended to refer to a physical and/or electrical connection between two or more elements, and may include other intervening elements. The pair of the first bit line metal lines BL BSM_p1 and BL BSM_p2 may extend in the Y-direction and are spaced apart from each other in the X-direction. That is, the pair of the first bit line metal lines BL BSM_p1 and BL BSM_p2 are implemented as buried bit lines.

The second memory cell Cell2 is electrically connected to a pair of the second bit line metal lines BL FSM_p1 and BL FSM_p2 and the pair of the lower word line metal lines WL_p1 and WL_p2, which are disposed at a first upper metal level on the upper surface of the substrate. The pair of the second bit line metal lines BL FSM_p1 and BL FSM_p2 extend in the Y-direction while being spaced apart from the first power supply metal line VDD toward both sides in the X-direction. Each of the second bit line metal lines BL FSM_p1 and BL FSM_p2 may be disposed at a position spaced apart from the first power supply metal line VDD, the pair of the lower word line metal lines WL_p1 and WL_p2 or the pair of the second power supply metal lines VSS in the X-direction.

According to some embodiments, the pair of the first bit line metal lines BL_BSM and the pair of the second bit line metal lines BL_FSM may be disposed on the same Y-axis while being spaced apart from each other in the Z-direction.

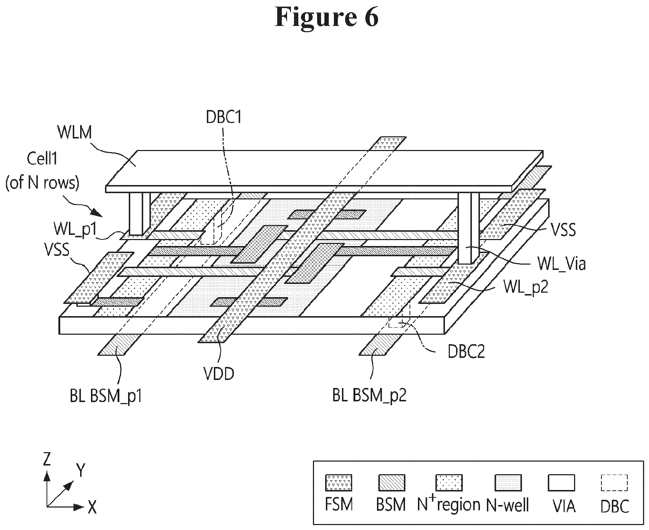

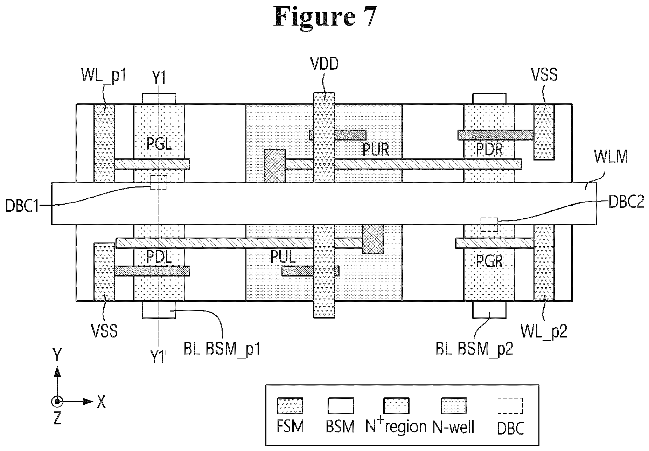

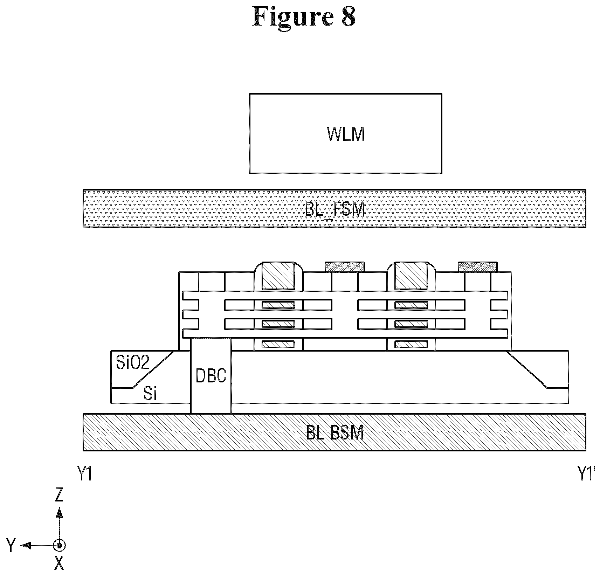

FIG. 6 is a conceptual perspective layout view illustrating an example arrangement of a first memory cell, according to one or more embodiments. FIG. 7 is a plan view illustrating the first memory cell of FIG. 6, and FIG. 8 is a cross-sectional view taken along line Y1-Y1' of the first memory cell of FIG. 7.

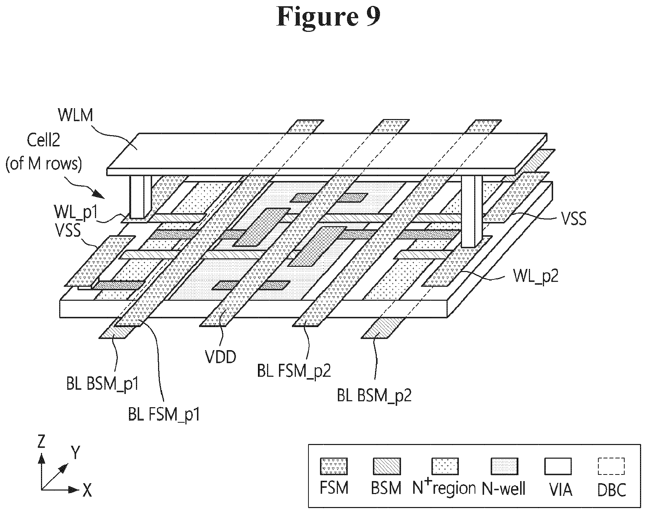

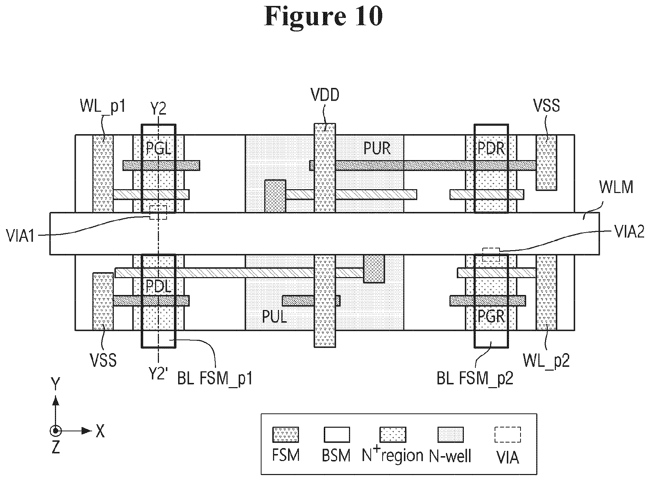

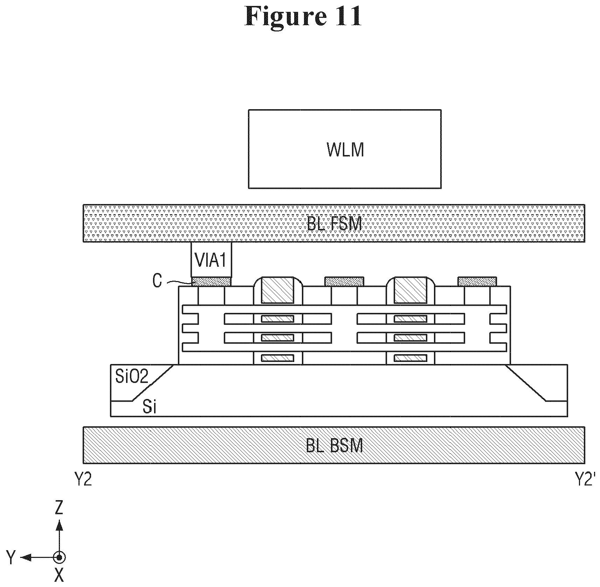

FIG. 9 is a conceptual perspective layout view illustrating an example arrangement of a second memory cell, according to one or more embodiments. FIG. 10 is a plan view illustrating the second memory cell of FIG. 9, and FIG. 11 is a cross-sectional view taken along line Y2-Y2' of the second memory cell of FIG. 10.

Referring to FIGS. 6 to 11, the first memory cell Cell1 and the second memory cell Cell2 may include six transistors in accordance with some embodiments. For example, each of the first memory cell Cell1 and the second memory cell Cell2 includes a first pull-up transistor PUL and a second pull-up transistor PUR, which are disposed in an N-type well (N-well) region below the power supply metal line VDD, and a first pull-down transistor PDL, a second pull-down transistor PDR, a first pass gate transistor PGL and a second pass gate transistor PGR, each of which is disposed in an N-type region (N+ region) corresponding to a source/drain region of a bit line/complementary bit line transistor. For example, the first pull-up transistor PUL, the first pull-down transistor PDL and the first pass gate transistor PGL may be transistors connected to a bit line metal line, and the second pull-up transistor PUR, the second pull-down transistor PDR and the second pass gate transistor PGR may be transistors connected to a complementary bit line metal line.

Referring to FIGS. 6 to 8, the first memory cell Cell1 includes a pair of first bit line metal lines BL BSM_p1 and BL BSM_p2 disposed at the lower metal level below the substrate (e.g, on a bottom surface of the substrate). The pair of first bit line metal lines BL BSM_p1 and BL BSM_p2 are connected to a source/drain metal of the bit line transistor and the complementary bit line transistor of the first memory cell. The first memory cell Cell1 may further include a direct backside contact (hereinafter, referred to as DBC). The DBC is disposed between an upper surface of the pair of first bit line metal lines BL BSM_p1 and BL BSM_p2 and a lower surface of the source/drain metal of the bit line transistor and the complementary bit line transistor of the first memory cell to electrically connect the first memory cell Cell1 to the first bit line metal line.

According to some embodiments, referring to FIGS. 7 and 8, the direct backside contacts DBC1, DBC2 of the first memory cell Cell1 is disposed below the N-type region (N+ region) corresponding to the source/drain region of the bit line transistor and the complementary bit line transistor, which are extended in the Y-direction . The DBC1 passes through a substrate Si in the Z-direction, and is electrically connected to the first bit line metal lines BL_BSM_p1, BL BSM_p2 extended in a direction Y1-Y1' on a lower surface of the substrate Si. In some embodiments, the substrate may include substrate Si and substrate SiO2.

The pair of lower word line metal lines WL_p1 and WL_p2 of the first memory cell Cell1 may be electrically connected to a gate electrode of the bit line transistor and a gate electrode of the complementary bit line transistor of the first memory cell Cell1, respectively.

The first memory cell Cell1 further includes an upper word line metal line WLM disposed at a second upper metal level above the first upper metal level in the Z-direction. The upper word line metal lines WLM may extend in the X-direction unlike the lower word line metal lines WL_p1 and WL_p2 (which may extend in the Y-direction), and may be metal lines having a width in the Y-direction greater than a width in the X-direction of the lower word line metal lines WL_p1 and WL_p2. In some embodiments, the first memory cell Cell1 further includes a word line via WL_Via.

The word line via WL_Via is disposed between the upper surface of the lower word line metal lines WL_p1 and WL_p2 and the lower surface of the upper word line metal line WLM to electrically connect the first memory cell Cell1 to the upper word line metal line WLM.

Referring to FIGS. 9-11, the second memory cell Cell2 includes a pair of second bit line metal lines BL FSM_p1 and BL FSM_p2 disposed at a first upper metal level on the substrate. As described above with reference to FIG. 5, the (2-1)th bit line metal line BL FSM_p1 extends in the Y-direction while being spaced apart from the first power supply metal line VDD and the second power supply metal line VSS in the X direction. The (2-2)th bit line metal line BL FSM_p2 extends in the Y-direction while being spaced apart from the first power supply metal line VDD and the lower word line metal line WL_p2 in the X-direction.

The pair of second bit line metal lines BL FSM_p1 and BL FSM_p2 are connected to the source/drain metal of the bit line transistor and the complementary bit line transistor of the second memory cell Cell2. The second memory cell Cell2 may further include bit line vias VIA1, VIA2. The bit line vias VIA1, VIA2 are disposed between the lower surface of the pair of second bit line metal lines BL FSM_p1 and BL FSM_p2 and the upper surface of the source/drain metal of the bit line transistor and the complementary bit line transistor of the second memory cell Cell2 to electrically connect the second memory cell Cell2 to the second bit line metal line.

The second memory cell Cell2 further includes an upper word line metal line WLM disposed at a second upper metal level above the first upper metal level in the Z-direction. A word line signal different from that of the upper word line metal line WLM to which the first memory cell Cell1 is connected may be applied to the upper word line metal line WLM to which the second memory cell Cell2 is connected.

According to some embodiments, referring to FIGS. 10 and 11, the bit line vias VIA1, VIA2 are disposed on a metal of the N-type region (N+ region) corresponding to the source/drain region of the bit line transistor and the complementary bit line transistor, which are extended in the Y-direction. Also, the bit line vias VIA1, VIA2 is disposed between the upper surface of the second memory cell Cell2, an upper portion of the N-type region (N+ region) and the second bit line metal line BL FSM extending in a direction Y2-Y2' to electrically connect the source/drain metal on the N-type region (N+ region) with the second bit line metal line BL_FSM.

The pair of first bit line metal lines BL_BSM_p1 and BL_BSM_p2 passing through the second memory cell Cell2 may be disposed in the second memory cell Cell2 at a lower metal level below the substrate Si. However, the pair of first bit line metal lines BL_BSM_p1 and BL_BSM_p2 are not electrically connected to the second memory cell Cell2. That is, since there is no DBC (shown in FIGS. 7 and 8), the second memory cell Cell2 may operate independently of the first memory cell Cell1 connected to the first bit line metal line.

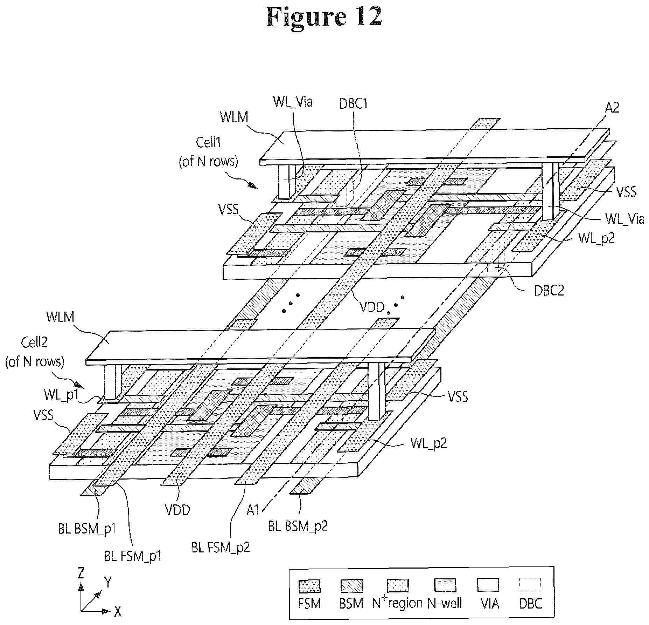

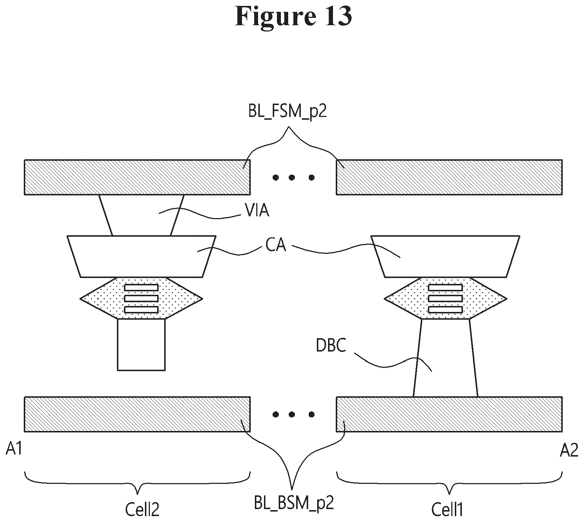

FIG. 12 is a conceptual perspective layout view illustrating one column of the memory cell array of FIG. 3, and FIG. 13 is a cross-sectional view taken along line A1-A2 of the first memory cell and the second memory cell shown in FIG. 12, according to one or more embodiments.

Referring to FIGS. 12 and 13, any one column included in the memory cell array may be implemented as shown in FIG. 12. That is, the pair of first bit line metal lines BL BSM_p1 and BL BSM_p2 may extend lengthwise in the Y-direction below (i.e., on a lower surface of) the substrate in which all memory cells belonging to the same column are disposed, and the pair of second bit line metal lines BL FSM_p1 and BL FSM_p2 may extend in the Y-direction on the substrate in which some memory cells belonging to the same column are disposed.

In the cross section of A1-A2 of FIG. 13, the first memory cell Cell1 is connected to the second bit line metal line BL_BSM through the DBC below a source/drain active pattern of the bit line transistor. The second memory cell Cell2 is connected to the first bit line metal line BL_FSM through a bit line via VIA on the upper surface of the source/drain metal over the source/drain active pattern of the bit line transistor. In some embodiments, contact may be disposed between the second bit line metal line BL BSM and the first bit line metal line BL FSM.

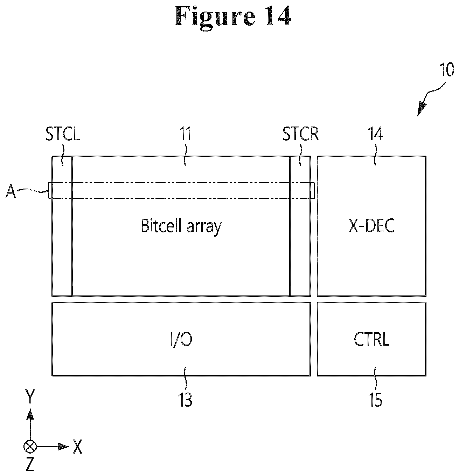

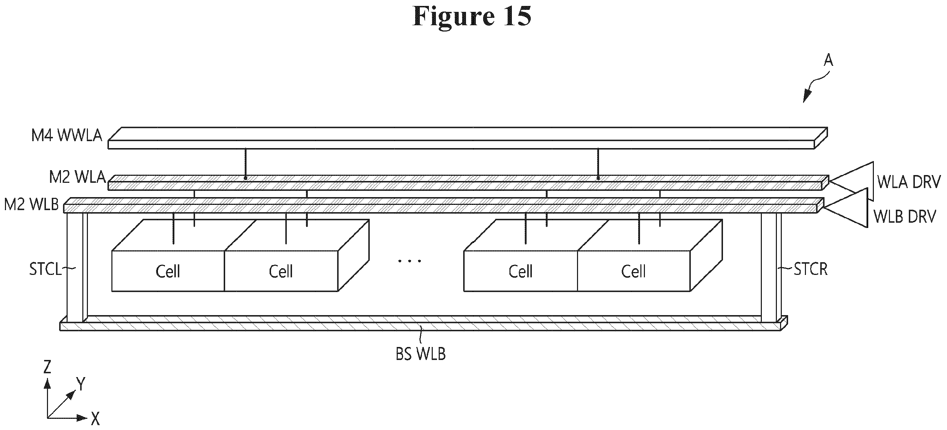

FIG. 14 is a block diagram illustrating a memory device according to some embodiments, and FIG. 15 is a detailed conceptual view illustrating a word line metal line of a memory cell array according to some embodiments. For convenience of description, a repeated description of FIG. 1 will be omitted.

Referring to FIG. 14, the memory cell array 11 may further include through contact structure regions STCL and STCR at both ends of the memory cell array. Each row of a memory cell in the memory cell array is extended along the first direction X, and each column thereof is extended along the second direction Y. Each row includes a plurality of word lines WL extended lengthwise along the first direction X, and each column includes a plurality of bit lines BL extended lengthwise along the second direction Y. The through contact structure regions are positioned at both ends of each word line WL, respectively.

The memory cell array 11 includes a plurality of bit cells, and one bit cell may be implemented as a single port bit cell, or may be implemented as a two-port bit cell or a dual-port bit cell in accordance with various embodiments. The two-port bit cell and the dual-port bit cell may further include two word lines and two pass transistors than the single port bit cell, in which a read path and a write path are separated from each other, using the separated word lines in the bit cell, to simultaneously access the plurality of bit cells. Hereinafter, an embodiment of the memory device implemented by the two-port bit cell will be described, but the scope of the present disclosure is not limited thereto, and the technical spirits of the present disclosure may be also applied to the single port bit cell.

One word line shown in a region A of FIG. 14 will be described in more detail with reference to FIG. 15. The memory cells belonging to any one row are connected to two word line metal lines M2 WLA and M2 WLB extended in the X-direction. One end of each of the two word line metal lines M2 WLA and M2 WLB is electrically connected to drive circuits WLA DRV and WLB DRV in a row decoder 14. For example, the word line metal line M2 WLA may be connected to the drive circuit WLA DRV of a read port, and the word line metal line M2 WLB may be connected to the drive circuit WLB DRV of a write port. Alternatively, the word line metal line M2 WLA may be connected to the drive circuit WLA DRV of the write port, and the word line metal line M2 WLB may be connected to the drive circuit WLB DRV of the read port. The two word line metal lines M2 WLA and M2 WLB are referred to as a first sub word line metal line M2 WLA and a second sub word line metal line M2 WLB for convenience of description, but it will be apparent that the scope of the present disclosure is not limited thereto and the word line metal lines may be referred to as various terms.

In the memory device according to some embodiments, a signal path of the first sub word line metal line M2 WLA and a signal path of the second sub word line metal line M2 WLB may be disposed such that they are respectively separated into a frontside word line metal line M4 WWLA and a backside word line metal line BS WLB and then routed. That is, the sub word line metal lines of the two-port (or dual-port) bit cell are connected to a frontside word line metal line WWLA of an upper surface of a substrate Sub and a backside word line metal line BS WLB of a lower surface of the substrate, respectively.

The first sub word line metal line M2 WLA is electrically connected to the frontside word line metal line M4 WWLA disposed above the first and second sub word line metal lines M2 WLA and M2 WLB through at least one via. The second sub word line metal line M2 WLB is electrically connected to the backside word line metal line BS WLB disposed below the memory cells Cell through the through contact structures STCL and STCR. The backside word line metal line BS WLB is connected to the second sub word line metal line M2 WLB through a through contact structure, for example the through contact structure, disposed at both ends of the memory cell array 11. The frontside metal line M4 WWLA and the backside word line metal line BS WLB are extended in the X-direction and have wider width than the sub word line metal lines M2_WLA, M2 WLB.

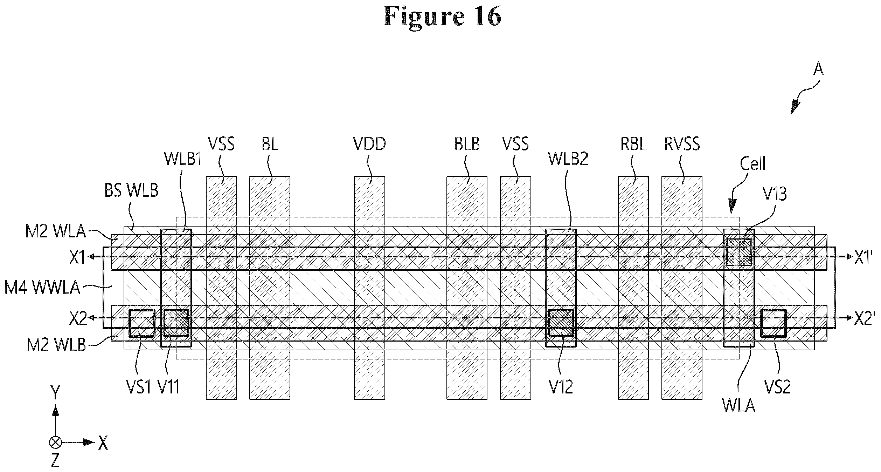

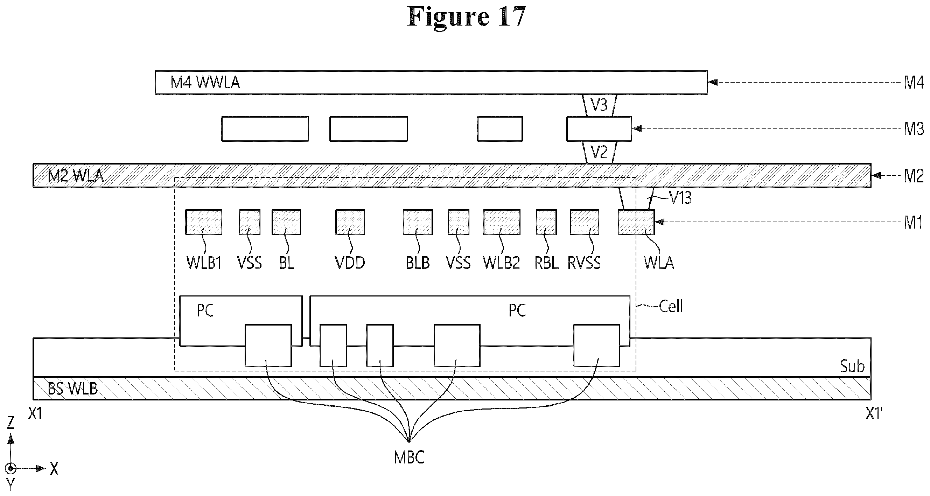

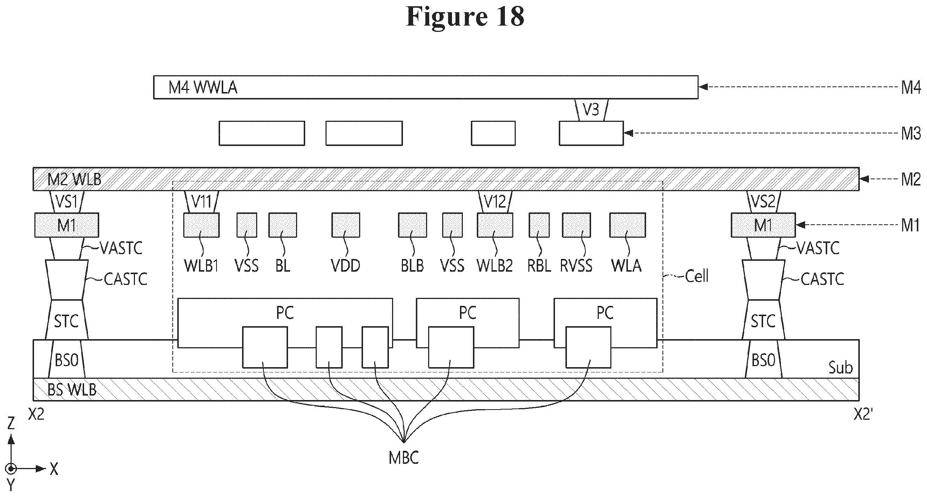

FIG. 16 is a plan view illustrating one row of a memory cell array 11 according to some embodiments, FIG. 17 is a cross-sectional view taken along line X1-X1' of FIG. 16, and FIG. 18 is a cross-sectional view taken along line X2-X2' of FIG. 16. Hereinafter, in describing an arrangement of metal wiring lines, the metal wiring line disposed directly above a gate electrode PC in the Z-direction is referred to as a first level metal line M1, and then the subsequent metal lines in an upper Z-direction are referred to as a second level metal line M2, a third level metal line M3, and a fourth level metal line M4.

Referring to FIGS. 16, 17 and 18, the bit cell Cell includes a first word line connection metal line WLB1, a second word line connection metal line WLB2, and a third word line connection metal line WLA, bit line metal lines BL and RBL, a complementary bit line metal line BLB, power supply line VSS and VDD, first and second sub word line metal lines M2 WLA and M2 WLB, a frontside word line metal line M4 WWLA, and a backside word line metal line BS WLB. The first word line connection metal line WLB1, the second word line connection metal line WLB2, the third word line connection metal line WLA, the bit line metal lines BL and RBL, the complementary bit line metal line BLB and the power supply lines VSS and VDD are respectively spaced apart from one another in the X-direction at predetermined intervals and disposed in parallel while extending in the Y-direction.

The first sub word line metal line M2 WLA and the second sub word line metal line M2 WLB, which are disposed on the second level metal line M2 on a Z-axis plane, are spaced apart from each other in the Y-direction, and are disposed in parallel while extending in the X-direction.

The frontside word line metal line M4 WWLA is disposed on a fourth level metal lines M4 on a Z-axis plane of an upper surface corresponding to the first sub word line metal line M2 WLA and the second sub word line metal line M2 WLB, and is disposed to be extended in the X-direction. The backside word line metal line BS WLB is disposed on a lower surface of a substrate corresponding to the first sub word line metal line M2 WLA and the second sub word line metal line M2 WLB, and is disposed to be extended in the X-direction. The frontside word line metal line M4 WWLA and the backside word line metal line BS WLB may have a width wider than a width of each of the first sub word line metal line M2 WLA and the second sub word line metal line M2 WLB in the Y-direction. The first sub word line metal line M2 WLA and the second sub word line metal line M2 WLB may have the same width in the Y-direction.

In the present disclosure, the embodiments of the present disclosure in FIGS. 17 and 18 are not limited to various connection relations between the gate electrode PC or a source/drain contact CA and the first level metal lines M1 in the cell region, and thus a description of the connection between the first level metal lines M1 and the gate electrode PC in the cell region Cell will be omitted.

Referring to the cross-section X1-X1' of FIG. 17, the first sub word line metal line M2 WLA may be disposed on the second level metal line M2, and the first sub word line metal line M2 WLA is electrically connected to the frontside word line metal line M4 WWLA disposed on the fourth level metal line M4 through vias V2 and V3 and the third level metal line M3. However, the first sub word line metal line M2 WLA is not connected to the backside word line metal line BS WLB disposed on the lower surface of the substrate Sub.

The frontside word line metal line M4 WWLA has a width in the Y-direction, which is greater than that of each of the first sub word line metal line M2 WLA and the second sub word line metal line M2 WLB. That is, a width of the frontside word line metal line M4 WWLA is wider than each width of the first sub word line metal line M2 WLA and the second sub word line metal line M2 WLB. A width of the first sub word line metal line M2 WLA is same or similar as a width of the second sub word line metal line M2 WLB. As the width of the frontside word line metal line M4 WWLA is wider, the resistance of the word line metal line may be reduced. In addition, the width of the sub word line metal line having an M2 level may be adjusted by a signal margin generated as the resistance of the word line metal line is reduced, so that it may be expected to resolve internal resistance (IR) drop of the frontside word line metal line M4 WWLA.

Referring to the cross-section X2-X2' of FIG. 18, the second sub word line metal line M2 WLB may be disposed on the second level metal line M2, and the second sub word line metal line M2 WLB is electrically connected to the backside word line metal line BS WLB below the substrate Sub through a through contact structure STC. Like the frontside word line metal line M4 WWLA, the backside word line metal line BS WLB has a width in the Y-direction, which is greater than that of each of the first sub word line metal line M2 WLA and the second sub word line metal line M2 WLB.

According to some embodiments, the backside word line metal line BS WLB of the lower surface of the substrate is connected to the second sub word line metal line M2 WLB through the through contact structure STC. The region of the through contact structure STC is disposed on edge sides of both ends of the memory cell array 11 in the X-direction in accordance with some embodiments, and thus the bit cells Cell are uniformly disposed within the memory cell array, whereby a critical pass imbalance of a signal is resolved. In the present disclosure, the through contact structure STC is a structure for connecting a metal wiring line of any one of the first to fourth level metal lines M1, M2, M3 and M4 of the upper surface of the substrate from the backside word line metal line of the lower surface of the substrate, and the through contact structure STC may be variously referred to as a backside contact structure, a backside conductor structure, a single-tap cell structure and the like in accordance with various embodiments.

A backside line structure BS0 formed in the substrate Sub is connected to the second sub word line metal line M2 WLB through the through contact structure including a plurality of stacked signal tap cell structures STC, CASTC and VASTC, a first level metal line pattern M1 and a via VS1/VS2 on the substrate Sub. Although not shown, the signal tap cell structure STC includes a plurality of through contacts stacked in the Z-direction, and each through contact may include a through conductive film and a through spacer. The through conductive film may include at least one of, for example, aluminum (Al), copper (Cu), tungsten (W), molybdenum (Mo), cobalt (Co), ruthenium (Ru) or their alloy as a conductive material, and the through spacer may be formed of an insulating material surrounding the through conductive film. The signal tap cell structure may transfer a signal of the backside word line metal line BS WLB to the second sub word line metal line M2 WLB. The first through contact STC may be formed at the same level as the gate electrode PC on the substrate Sub in the Z-direction, the second through contact CASTC may be formed at the same level as a gate contact CB3 or the source/drain contact CA in the Z-direction, and the third through contact VASTC may be formed at the same level as the via on the gate contact in the Z- direction.

However, the second sub word line metal line M2 WLB is not electrically connected to the frontside word line metal line M4 WWLA. A signal path of the second sub word line metal line M2 WLB is independent from a signal path of the first sub word line metal line M2 WLA.

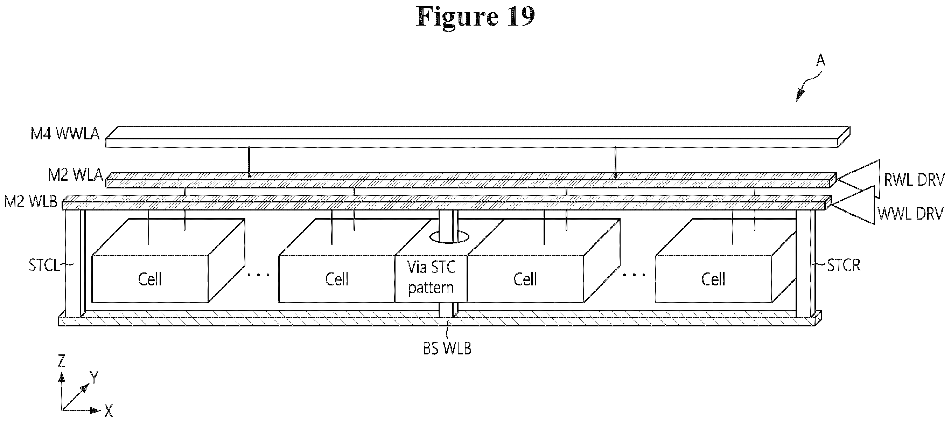

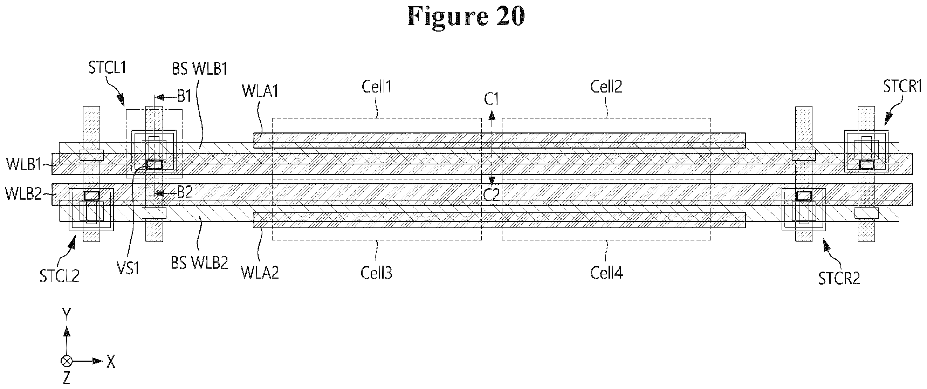

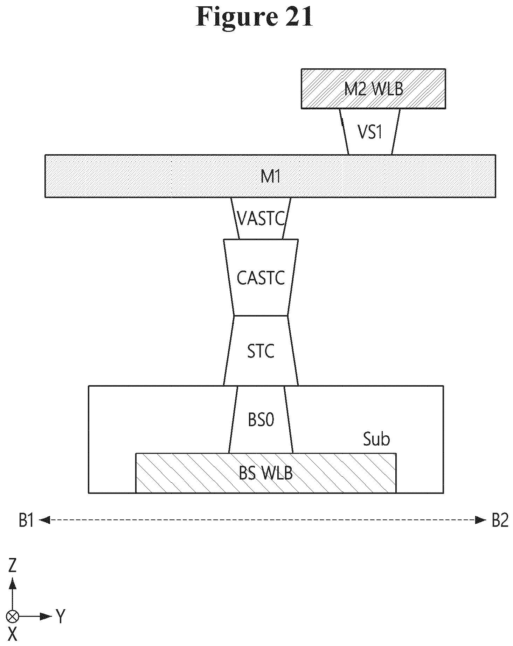

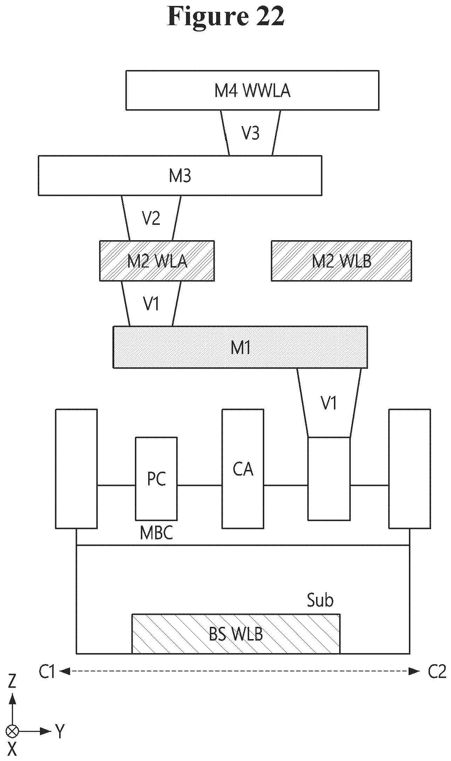

FIG. 19 is a detailed conceptual view illustrating a word line metal line of a memory cell array according to some embodiments, and FIG. 20 is a layout view illustrating one row in the memory cell array of FIG. 19. FIG. 21 is a cross-sectional view taken along line B1-B1' of FIG. 20 according to some embodiments, FIG. 22 is a cross-sectional view taken along line C1-C1' of FIG. 20 according to some embodiments. For convenience of description, a repeated description of FIG. 15 will be omitted.

One word line shown in the region A of FIG. 14 will be described in more detail with reference to FIG. 19. Memory cells belonging to any one row are connected to two word line metal lines M2 WLA and M2 WLB extending in the X-direction. The first sub word line metal line M2 WLA is electrically connected to the frontside metal line M4 WWLA disposed above the first and second sub word line metal lines M2 WLA and M2 WLB. The second sub word line metal line M2 WLB is electrically connected to the backside word line metal line BS WLB disposed below the memory cells Cell.

However, unlike the embodiment of FIG. 15, the through contact structure is further included in a middle point of the memory cell array 11 in the X-direction in a single row, that is, in the word line. The through contact structure disposed at the middle point of the memory cell array may be referred to as a via through contact pattern.

Each of the second sub word lines M2 WLB is connected to the backside word line metal line BS WLB by the through contact structure STC. In some embodiments, four bit cell arrays Cell1, Cell2, Cell3 and Cell4 disposed in two rows will be described by way of example. The through contact regions STCL1, STCR1, STCL2 and STCR2 are disposed at both ends of the four bit cell arrays in the X-direction. A via through contact pattern via STC pattern drawn in Fig. 19 is disposed between the memory cell arrays Cell1 and Cell2. Using the via through contact pattern via STC pattern, there is an advantage of place and routing (PnR) in design while more stably applying signals only with a relatively small area of the via through contact pattern without implementing any additional re-buffer circuit -which includes at least one transistor- that occupies a larger area even when a size of the memory cell array is large.

The through contact structure will be described in detail with reference to FIGs. 19 and 21. In the through contact structure, the backside word line metal line BS WLB is disposed below the substrate Sub, and the backside line structure BS0 is formed and disposed on the backside word line metal line BS WLB in the substrate. According to some embodiments, the through contact structure STC may be also referred to as various terms such as a backside contact structure or a backside conductor structure.

The through contact structures are disposed on an upper surface corresponding to the backside line structure BS0 on the substrate Sub. The through contact structure is connected to the second sub word line metal line M2 WLB through the first level metal line M1 and the via VS1. According to this arrangement, the second sub word line metal line M2 WLB may transfer a signal to the backside word line metal line BS WLB or a signal of the backside word line metal line BS WLB to the second sub word line metal line M2 WLB.

In some embodiments, the through contact structure includes first through contact STC, second through contact CASTC and third through contact VASTC. The first through contact STC may be formed at the same level as the gate electrode PC on the substrate Sub in the Z-direction, the second through contact CASTC may be formed at the same level as the gate contact CB3 or the source/drain contact CA in the Z-direction, and the third through contact VASTC may be formed at the same level as the via on the gate contact in the Z-direction. In some embodiments, the width of the first through contact STC may be gradually reduced toward the lower surface from the upper surface to the lower surface of the Z-axis. The width of the second through contact CASTC and the third through contact VASTC may be gradually reduced toward the lower surface from the upper surface of the Z-axis.

The third through contact VASTC is electrically connected to the second sub word line metal line M2 WLB through the first level metal line M1 and a via VS1.

A structure in which a sub word line metal line is connected to a frontside word line metal line will be described with reference to FIG. 22. The backside word line metal line BS WLB is disposed below the substrate Sub, and a cell active region MBC is disposed on the substrate Sub. The source/drain contact CA or the gate electrode PC is disposed on the cell active region MBC, and the first sub word line metal line M2 WLA is connected to the gate electrode PC through the via V1 and the first level metal line M1. The first sub word line metal line M2 WLA is connected to the frontside word line metal line M4 WWLA through the vias V2 and V3 and the third level metal line M3.

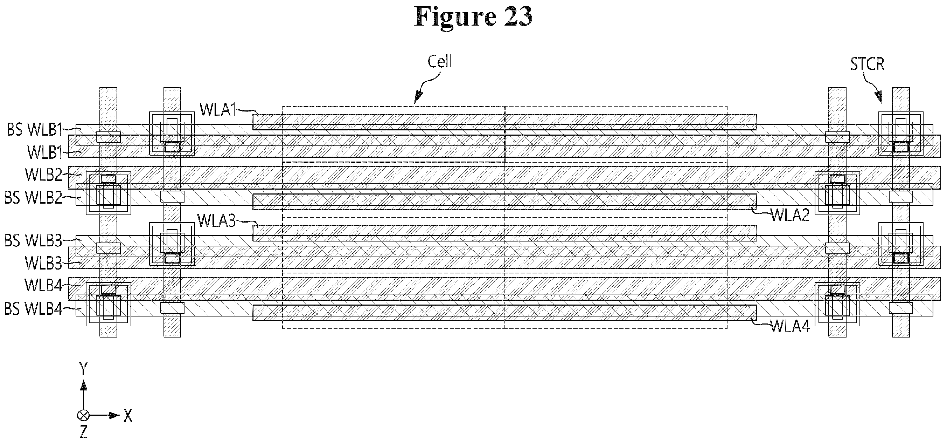

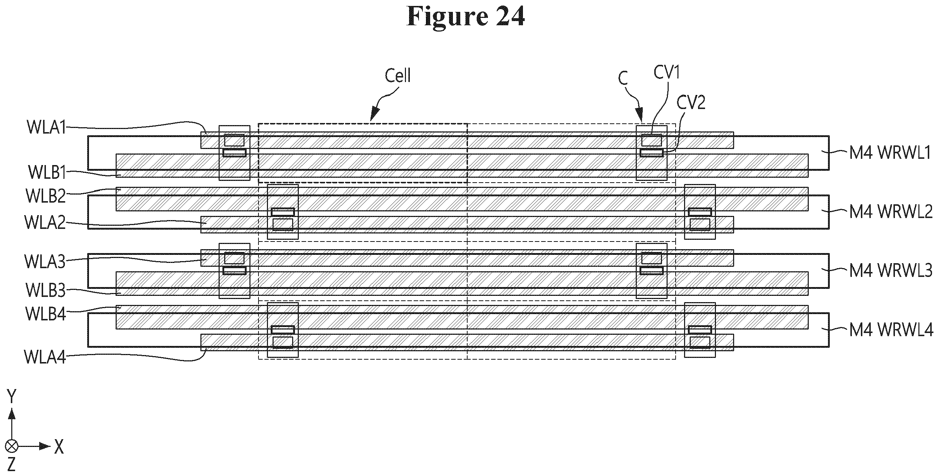

FIGS. 23 and 24 are layout views illustrating a memory cell array to describe word line arrangement according to some embodiments. For convenience of description, any connection for bit lines in the cell region Cell are not shown. FIG. 23 shows only second level metal lines from backside word line metal lines. FIG. 24 shows only frontside word line metal lines from second level metal lines.

Referring to FIGS. 23 and 24, the first sub word line metal line M2 WLA and the second sub word line metal line M2 WLB are spaced apart from each other by a predetermined interval in the Y-direction, and are disposed to be extended in the X-direction in the order of WLA1-WLB1, WLB2-WLA2, WLA3-WLB3 and WLB4-WLA4.

For example, the word line metal lines have a form in which word lines in an odd-numbered row and an even-numbered row of the memory cell, which are adjacent to each other, are disposed to be mirrored to each other in the Y-direction. That is, the lines WLB are disposed in parallel to face each other so that the odd-numbered row WLA1-WLB1 is mirrored to the even-numbered row WLB2-WLA2, and WLA1 and WLA2 are disposed at positions where they are mirrored to each other based on the X-axis. The odd-numbered row WLA3-WLB3 has the same arrangement as that of the odd-numbered row WLA1-WLB1 adjacent thereto.

The frontside word line metal line M4 WWL may be disposed at the center of an upper surface of each of the sub word line metal line M2 WLA and the sub word line metal line M2 WLB, and may be electrically connected to the first sub word line metal line M2 WLA through a third level metal pattern C connected through vias CV1 and CV2.

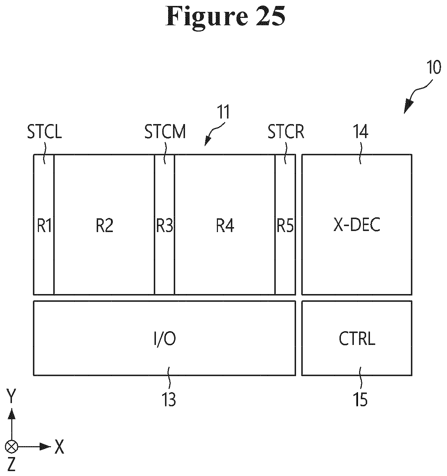

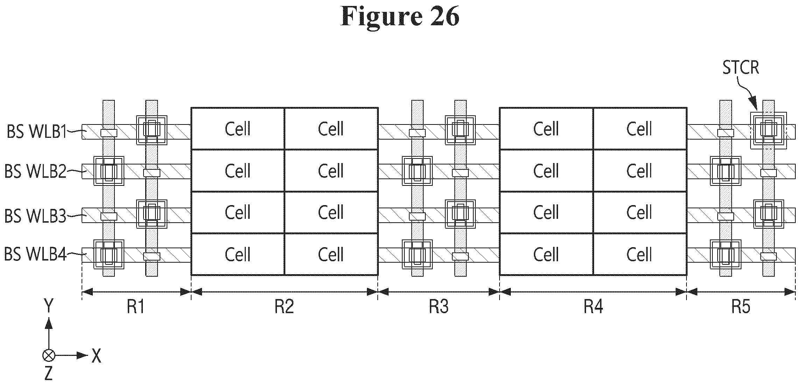

FIG. 25 is a block diagram illustrating a memory device to describe arrangement of a through contact region according to some embodiments. FIG. 26 is a layout view illustrating the memory cell array of FIG. 25. For convenience of description, the following description will be based on differences from FIG. 14.

Referring to FIGS. 25 and 26, when the number of bit cells included in the memory cell array is large in accordance with some embodiments, a through contact region may be included in both end regions and a middle region of the memory cell array. That is, in the memory cell array 11, a plurality of bit cells may be disposed in regions R2 and R4, and each through contact structure STCL, STCM, STCR for connection with the backside word line metal lines may be disposed in regions R1, R3 and R5.

In the memory device according to embodiments of the present disclosure, bit lines and word lines are disposed to be distributed per column on the upper surface and the lower surface of the substrate, so that overheads for routing in BEOL layer may be reduced. A metal line width of upper bit line or upper word line is implemented wider than prior, so that the resistance and capacitances are reduced between adjacent metal lines for the bit lines or the word lines. An additional area for routing of the bit lines or word lines is not required, whereby there is an advantage in view of place and routing (PnR).

Although the embodiments of the present disclosure have been described with reference to the accompanying drawings, it will be apparent to those skilled in the art that the present disclosure can be fabricated in various forms without being limited to the above-described embodiments and can be embodied in other specific forms without departing from technical spirits and essential characteristics of the present disclosure. Thus, the above embodiments are to be considered in all respects as illustrative and not restrictive.

## Claims

1. A memory device, comprising:
a memory cell array including a plurality of memory cells arranged in a plurality of columns and rows and including first and second memory cells in a same column and different rows, the plurality of columns intersecting the plurality of rows in a plan view;
a first bit line transistor electrically connected between the first memory cell and a first bit line metal line; and
a second bit line transistor electrically connected between the second memory cell and a second bit line metal line,
wherein the first bit line metal line is on an upper surface of the memory cell array, and the second bit line metal line is on a lower surface of the memory cell array opposite the upper surface of the memory cell array.

2. The memory device of claim 1, wherein each of the first and second memory cells is a static random access memory cell.

3. The memory device of claim 2, wherein each of the first and second memory cells includes a bit line transistor, a complementary bit line transistor and two inverters.

4. The memory device of claim 1, wherein each of the plurality of columns in the memory cell array includes a plurality of sub-groups,
a first sub-group of the plurality of sub-groups is electrically connected to a sense amplifier after the first memory cell is disposed in a first direction from an uppermost word line to a lowest word line in at least one of first column and then the second memory cell is disposed,
a second sub-group of the plurality of sub-groups is electrically connected to the sense amplifier after the second memory cell is disposed in the first direction in at least one of second column and then the second memory cell is disposed, and
the first column of the first sub-group and the second column of the second sub-group are alternately disposed in a second direction intersecting the first direction, the first and second directions being parallel to the upper surface of the memory cell array.

5. The memory device of claim 1, wherein the first bit line metal line is a frontside metal line on an upper surface of a substrate in which the plurality of memory cells are formed, and the second bit line metal line is a backside metal line on a lower surface of the substrate opposite the upper surface of the substrate.

6. The memory device of claim 4, further comprising a direct backside contact between an upper surface of the second bit line metal line and a lower surface of a source/drain metal of the second bit line transistor to electrically connect the second bit line metal line with the source/drain metal of the second bit line transistor.

7. The memory device of claim 4, further comprising a bit line via between a lower surface of the first bit line metal line and an upper surface of a source/drain metal of the first bit line transistor to electrically connect the first bit line metal with the source/drain metal of the first bit line transistor.

8. The memory device of claim 1, wherein the first bit line metal line and the second bit line metal line are respectively connected to sense amplifiers of a same column of the plurality of columns.

9. A memory device, comprising:
a pair of first bit line metal lines at a first metal level;
a memory cell array on a substrate above the first metal level, the memory cell array including first and second memory cells in a same column;
first and second power supply metal lines and a pair of second bit line metal lines at a second metal level above the substrate; and
a sense amplifier in the substrate and electrically connected to the pair of first bit line metal lines and the pair of second bit line metal lines,
wherein the first memory cell is connected to the pair of first bit line metal lines, and the second memory cell is connected to the pair of second bit line metal lines.

10. The memory device of claim 9, wherein each of the first and second memory cells is a static random access memory that includes a bit line transistor, a complementary bit line transistor and two inverters.

11. The memory device of claim 10, wherein the second memory cell includes a first bit line via between a lower surface of the second bit line metal line and an upper surface of a source/drain metal of the bit line transistor of the second memory cell to electrically connect the second memory cell to the second bit line metal line.

12. The memory device of claim 11, wherein the second memory cell includes a second bit line via between a lower surface of a second complementary bit line metal line and an upper surface of a source/drain metal of the complementary bit line transistor of the second memory cell to electrically connect the second memory cell to the second complementary bit line metal line.

13. The memory device of claim 10, wherein the first memory cell includes a first direct backside contact between an upper surface of a first bit line metal line and a lower surface of a source/drain metal of the bit line transistor of the first memory cell to electrically connect the first bit line metal line with the source/drain metal of the bit line transistor of the first memory cell.

14. The memory device of claim 13, wherein the first memory cell includes a second direct backside contact between an upper surface of a second complementary bit line metal line and a lower surface of a source/drain metal of the complementary bit line transistor of the second memory cell to electrically connect the second complementary bit line metal line with the source/drain metal of the complementary bit line transistor of the second memory cell.

15. A memory device, comprising:
a memory cell array including a plurality of memory cells in a substrate;
a pair of first bit line metal lines spaced apart from each other in a second direction at a lower metal level below the substrate in a third direction and extending in a first direction, the first and second directions intersecting one another and being parallel to an upper surface of the substrate, and the third direction being perpendicular to the upper surface of the substrate and to the first and second directions;
a first power supply metal line extending in the first direction at a first upper metal level above the substrate in the third direction;
a pair of second power supply metal lines spaced apart from the pair of first power supply metal lines in the second direction at the first upper metal level and extending in the first direction;
a pair of lower word line metal lines spaced apart from the pair of second power supply metal lines in the second direction on a first directional axis the same as that of the pair of second power supply metal lines at the first upper metal level;
a pair of second bit line metal lines between each of the pair of second power supply metal lines and the first power supply metal line at the first upper metal level and extending in the first direction; and
a plurality of upper word line metal lines extending in the second direction at a second upper metal level above the first upper metal level in the third direction.
